# EUROPEAN PATENT APPLICATION

(11) **EP 1 528 598 A1**
(43) Date of publication of application: **04.05.2005**
(21) Application number: 04105281.2
(22) Date of filing: 25.10.2004
(51) Int. Cl.: H01L 29/737, H01L 29/732, H01L 21/331, H01L 29/10

(54) **Vertical PNP transistor and method of manufacturing the same**

(30) Priority: 31.10.2003 DE 10351100
(71) Applicant: TEXAS INSTRUMENTS DEUTSCHLAND GMBH, 85356 Freising (DE)
(72) Inventor: YASUDA, Hiroshi, 81927 Munich (DE); EL-KAREH, Badih, 85368 Wang (DE); SCHIEKOFER, Manfred, 85356 Freising (DE); BALSTER, Scott, 80992 Munich (DE)
(74) Representative: Holt, Michael

(57) **Abstract**

A method of producing a vertical bipolar PNP transistor is disclosed. The phosphorous profile in the base layer is controlled. Carbon that is incorporated in the base layer in the vicinity of the base-collector junction suppresses the diffusion of phosphorous deeper than implanted in a subsequent thermal step. PNP transistors with a narrow phosphorous-doped base can thus be manufactured with a cut-off frequency increased from 23 GHz to 30 GHz.

## Description

The present invention relates to a method of producing a vertical PNP transistor from a semiconductor material, comprising the steps of providing a collector layer, forming a base layer on said collector layer, doping said base layer with phosphorous and forming an emitter layer on top of said base layer. The present invention further relates to a vertical PNP transistor produced by this method.

Integrated circuits often include vertical PNP transistors that are transistors with superposed layers. One of the general requirements for high performance analog circuits is the bipolar high speed and low base resistance. In order to meet both requirements, the base profile should be narrow with a high dopant concentration.

One commonly used N-dopant for the base layer of PNP transistors is phosphorous, but with its high diffusivity in silicon there are no narrow base profiles obtainable. In fact, phosphorous diffuses in a following annealing step into the underlying layer, thus unavoidably broadening the base layer.

Another commonly used N-dopant for the base layer of PNP transistors is arsenic. Arsenic has a reduced diffusivity and if the thermal budget after arsenic base implant is kept reasonably low, arsenic does not diffuse so much and the final base profile is almost defined by implant condition. Therefore arsenic is preferred for high-speed applications. To improve performance of PNP transistors with an arsenic doped base, the arsenic low energy and high dose implant condition must be optimized. Lowering the implant energy decreases the penetration depth of arsenic but increases the amount of arsenic atoms captured by the screen oxide. This leads to an undesirable large process fluctuation. On the other hand, increasing the implantation dose while maintaining the low energy will lead to a very high concentration of arsenic at the surface of the base layer, which will hardly decrease in the following annealing step due to the low diffusivity of arsenic. This high dopant concentration may later lead to emitter-base junction leakages at the emitter periphery. All considered, there is a clear dead end to improve PNP transistor performance by only modifying the arsenic implant condition.

The present invention provides a method of producing a vertical bipolar PNP transistor comprising the steps of incorporating carbon in the base layer only in the vicinity of a junction zone between the collector layer and the base layer, doping said base layer with phosphorous and subjecting the doped base layer to a thermal treatment such that phosphorous is allowed to diffuse out from the surface area of the base layer and towards said junction zone and phosphorous is prevented from diffusing towards the junction zone by the presence of carbon.

It is known that carbon reduces the diffusivity of phosphorous. By introducing carbon into the base layer in the vicinity of the base-collector junction depth only, the diffusion of phosphorous into the collector is suppressed.

In a preferred embodiment, the base layer is formed epitaxially and the carbon is incorporated in-situ, while the doping of the base layer with phosphorous is performed at a low energy level appropriate to provide a high surface concentration of phosphorous in the base layer prior to the thermal treatment.

The high phosphorous concentration near the surface caused by low energy implant can, on the one hand, diffuse out quickly and, on the other hand, diffuse towards the junction zone, thus increasing the concentration of phosphorous in the base layer.

The present invention further provides a vertical bipolar PNP transistor formed of a semiconductor material and having a collector layer, a base layer on top of the collector layer with a collector-base junction zone between the collector and base layers, and an emitter layer on top of the base layer with an emitter-base junction zone between the emitter and base layers. The base layer is doped with carbon in the vicinity of the collector-base junction zone only and is N-doped with phosphorous, such that the presence of phosphorous atoms is substantially limited to a thickness of the base layer where carbon atoms are not present.

According to the present invention, the carbon and phosphorous atoms can be in-situ incorporated or implanted. Further preferred embodiments are described in the claims.

Details and advantages of the invention will now be described with reference to the accompanying drawings in which:
Figure 1 shows schematically the layers of a vertical PNP transistor; and
Figure 2 is a schematic of the phosphorous profile in the base layer with and without carbon added.

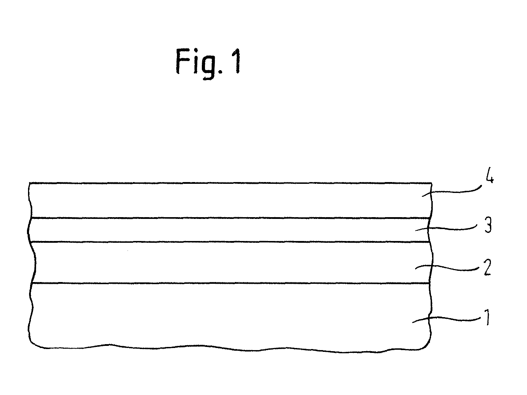

Figure 1 shows schematically the superposed layers of a vertical bipolar PNP transistor, where 1 is a substrate, 2 is a P-doped collector layer, 3 is an N-doped base layer and 4 is a P-doped emitter layer. These layers are conventionally grown epitaxially on the substrate. In the case of a high frequency transistor, the thickness of the base layer, the dopant concentration and the dopant profile are essential for high speed.

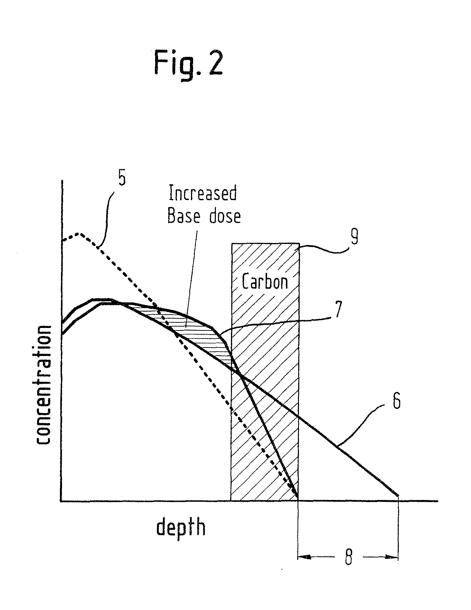

Figure 2 shows doping profiles of a base layer of a vertical PNP transistor. In Figure 2, zero depth corresponds to the interface between the emitter and base layers. The dashed line 5 in the graph shows the concentration of phosphorous as implanted. The dashed line 6 shows the phosphorous profile that would result after an annealing step, if no carbon were present in the base layer. A shaded rectangle 9 indicates a zone of a depth in the base layer where carbon is present. Line 7 in Figure 2 shows the phosphorous concentration with the presence of carbon in the base zone marked by rectangle 9. As can be seen, the phosphorous concentration sharply decreases from a depth where carbon is present, and disappears at a depth beyond the presence of carbon, which corresponds to the base/collector interface. Without the presence of carbon, the depth (or width) of the base layer would be extended towards the collector layer by an amount indicated in Figure 2 by a difference 8 in depth between lines 6 and 7.

Referring in more detail to line 5 in Figure 2, an epitaxial silicon or silicon germanium layer would be conventionally deposited onto the collector layer in order to form the base layer. Phosphorous atoms are introduced into this layer by low energy and high dose ion implantation. The resulting phosphorous concentration in the base layer is represented by the dashed line 5 of Figure 2. The concentration is very high near the surface and decreases with increasing depth. The phosphorous concentration after a subsequent thermal heating step, the annealing, is shown by dashed line 6. The concentration at the surface of the base layer has decreased. Due to the high diffusivity of phosphorous in silicon, part of the phosphorous atoms has diffused out. The phosphorous concentration at the base- collector junction has increased and phosphorous atoms are now deeper in the layer than implanted thus broadening the base width.

According to the invention, carbon 9 is incorporated in the base layer in the vicinity of the junction between the collector and base layers. To form the base layer, an epitaxial silicon or silicon-germanium layer is deposited onto the collector layer. This deposition is usually performed by a chemical vapor deposition technique (CVD) . This is done in a chamber, where the appropriate chemical components are in a source cabinet and react to form a vapor, containing the atoms or molecules that deposit on the substrate surface. It is possible to have several different kinds of atoms in the vapor and thus to deposit dopant atoms at the same time as the atoms for the base layer. This in-situ doping process is well known by those skilled in the art and comprises here depositing at the same time silicon and carbon, or silicon, germanium and carbon atoms. The in-situ doping is a well-controlled process and the carbon atoms are incorporated exactly in the wanted depth. Thereafter, the growing of the base layer is continued without carbon atoms. Alternatively, the incorporation of carbon is done by ion implantation.

The resulting carbon concentration is represented in Figure 2 by the shaded rectangle 9. Once the base layer growth is finished, phosphorous atoms are introduced by low energy and high dose ion implantation. The phosphorous concentration after the subsequent thermal heating step, the annealing, is shown by line 7. The concentration at the surface of the base layer has decreased compared to the concentration as implanted. Due to the high diffusivity of phosphorous in silicon, part of the phosphorous atoms has diffused out and part has diffused deeper into the base layer. As the incorporated carbon substantially reduces the diffusion of phosphorous, the phosphorous concentration in the thickness of the base layer, where carbon atoms are not present, is increased.

Thus, the invention leads to an increased base dose, but confined to a narrow width, as indicated in Figure 2. The increased base dose corresponds to a lower base resistance of the transistor. The invention also leads to a reduction of base width as indicated at 8 in Figure 2, because the diffusion of phosphorous atoms deeper than implanted is stopped. A reduced base width means a higher cut-off frequency. As the base dose was increased at the same time, no punch through between emitter and collector occurs. It is also possible to dope the base layer with the phosphorous atoms in-situ rather than to implant phosphorous. Fabrication of a vertical PNP transistor is continued conventionally by the deposition of an emitter layer.

The invention does not affect the conventional process steps that can be performed as usual. No additional process tools are required.

With the invention, the cut-off frequency of a PNP transistor was increased from 23 GHz to 29 GHz. No punch-through between collector and emitter occurred.

## Claims

1. A method of producing a vertical bipolar PNP transistor from a semiconductor material, comprising the steps of
(a) providing a collector layer;
(b) forming a base layer on said collector layer with a junction zone between said collector and base layers;
(c) incorporating carbon in said base layer in the vicinity of said junction zone;
(d) doping said base layer with phosphorous;
(e) subjecting the doped base layer to a thermal treatment such that
(e1) phosphorous is allowed to diffuse out from the surface area of the base layer and towards said junction zone, and
(e2) phosphorous is prevented from diffusing towards the junction zone by the presence of carbon; and
(f) forming an emitter layer on top of said base layer.

2. The method of claim 1, wherein the base layer is formed epitaxially.

3. The method of claim 2, wherein carbon is incorporated in the base layer by in-situ doping.

4. The method according to any of claims 1 to 3, wherein doping of the base layer with phosphorous is performed by ion implantation .

5. The method of claim 4, wherein the ion implantation is performed at a low energy level appropriate to provide a high surface concentration of phosphorous in the base layer prior to the thermal treatment.

6. The method according to any of claims 1 to 5, wherein the semiconductor material is silicon.

7. The method according to any of claims 1 to 5, wherein the semiconductor material is silicon-germanium.

8. A vertical bipolar PNP transistor produced by the method according to any of the preceding claims.

9. A vertical bipolar PNP transistor formed of a semiconductor material and having a collector layer, a base layer on top of the collector layer with a collector-base junction zone between said collector and base layers, and an emitter layer on top of the base layer with an emitter-base junction zone between said emitter and base layers, the base layer being doped with carbon in the vicinity of the collector-base junction zone and being N-doped with phosphorous such that the presence of phosphorous atoms is substantially limited to a thickness of the base layer where carbon atoms are not present.

10. The transistor of claim 9, wherein the base layer has a phosphorous concentration profile that
- increases from the vicinity of the emitter-base junction zone to a first predetermined depth of the base layer,
- decreases from the first predetermined depth to a second predetermined depth of the base layer at a first rate, and
- decreases from the second predetermined depth to a third predetermined depth of the base layer at a second rate greater than the first rate;
carbon atoms being present in a depth range of the base layer between said second and third predetermined depths.

11. The transistor of claim 10, wherein the first, second and third predetermined depths are about 20 nm, about 80 nm and about 120 nm, respectively.
